# EUROPÄISCHE PATENTSCHRIFT

(11) **EP 0 642 944 B1**
(45) Veröffentlichungstag und Bekanntmachung des Hinweises auf die Patenterteilung: **24.09.1997**
(21) Anmeldenummer: 94111150.2
(22) Anmeldetag: 18.07.1994
(51) Int. Cl.: B60K 1/04, H02J 7/00, H05K 7/20

(54) **Kühlvorrichtung für ein Batterieladegerät und einen Bordnetzwandler in Elektrofahrzeugen**
Cooling device for a battery charger and an on-board voltage converter in electric vehicles
Dispositif de refroidissement pour un chargeur de batterie et un convertisseur de tension à bord pour véhicule électrique

(30) Priorität: 09.09.1993 DE 4330618
(43) Veröffentlichungstag der Anmeldung: 15.03.1995
(73) Patentinhaber: Bayerische Motoren Werke Aktiengesellschaft, 80788 München (DE)
(72) Erfinder: Schumann, Anton, D-81243 München (DE)

(56) Entgegenhaltungen:
- DE-A- 4 114 576
- DE-U- 9 209 636
- ABB-Review, ASEA BROWN BOVERI (CH), 10/1990, Seite 10

## Beschreibung

Die Erfindung betrifft eine Kühlvorrichtung für ein fahrzeuginternes Batterieladegerät und einen Bordnetzwandler in Elektrofahrzeugen.

In Elektrofahrzeugen ist allgemein bekannt, ein fahrzeuginternes Batterieladegerät zum Aufladen der Antriebsbatterie über eine 220 V-Wechselspannung vorzusehen. Darüber hinaus enthalten bekannte Elektrofahrzeuge einen Bordnetzwandler, der zum Wandeln der relativ hohen Spannung der Antriebsbatterie in die 12 V-Spannung zur Versorgung konventioneller elektrischer Fahrzeug-Einrichtungen dient. Sowohl das Batterieladegerät als auch der Bordnetzwandler geben bei Betrieb eine hohe Verlustleistung in Form von Wärme ab, aufgrund derer beide elektrische Geräte gekühlt werden müssen. Es ist bekannt, für Batterieladegeräte und Bordnetzwandler separate Kühlvorrichtungen vorzusehen. Beispielsweise werden Batterieladegeräte üblicherweise luftgekühlt, wobei sie mit einem Kühlblech verbunden sind, das vorzugsweise außerhalb des Fahrzeuginnenraumes angebracht ist, um einen Hitzestau zu vermeiden. Als Kühlvorrichtung für Bordnetzwandler sind sowohl luftgekühlte als auch wassergekühlte Kühlbleche bekannt. Die getrennten Kühlvorrichtungen für das Batterieladegerät und den Bordnetzwandler tragen zur Gewichtserhöhung des Fahrzeuges bei, die gerade bei Elektrofahrzeugen unerwünscht ist.

In dem DE-U-92 09 636 ist im Zusammenhang mit modularen Bordnetzumrichtern einer Elektrolokomotive ein Stand der Technik (ABB-Technik, september 1990, Seiten 3-10; siehe auch english-sprachige Schwester zeitschrift ABB-Review, 10/1990, Seite 10) zitiert, in dem gezeigt ist, daß Leistungshalbleiter an sich jeweils eines Umrichters gemeinsam auf einem Kühlkörper montiert sind.

Es ist Aufgabe der Erfindung, die Reichweite eines Elektrofahrzeuges durch Gewichtsreduzierung zu verbessern.

Diese Aufgabe wird durch die kennzeichnenden Merkmale des Patentanspruchs 1 gelöst.
Erfindungsgemäß wird vorgesehen, sowohl das Batterieladegerät als auch den Bordnetzwandler an einem gemeinsamen Kühlblech zu befestigen.
Der Erfindung liegt die Erkenntnis zugrunde, daß das Batterieladegerät und der Bordnetzwandler nie gleichzeitig betrieben werden. Das Batterieladegerät ist lediglich in Betrieb, wenn das Fahrzeug im Stillstand an der Steckdose angeschlossen ist. Dagegen arbeitet der Bordnetzwandler nur dann, wenn das Fahrzeug fährt und elektrische Fahrzeug-Einrichtungen, wie Beleuchtung, Steuergeräte und Scheibenwischer, eingeschaltet sind. Daher ist auch ein gemeinsames Kühlblech nicht größer auszulegen, als ein Kühlblech, mit dem bisher nur das Batterieladegerät oder der Bordnetzwandler allein gekühlt wurde.
Mit dieser erfindungsgemäßen Vorrichtung wird bei gleichbleibender Kühlleistung sowohl eine Gewichts- als auch eine Platzreduzierung erreicht.

Eine vorteilhafte Ausgestaltung der Erfindung ist der Gegenstand des Patentanspruchs 2.

Vorzugsweise wird das Kühlblech flüssigkeitsgekühlt. Flüssigkeitskühlung erreicht beispielsweise gegenüber Luftkühlung eine bessere Kühlleistung. Dadurch kann sowohl das Batterieladegerät als auch der Bordnetzwandler mit dem gemeinsamen Kühlblech an beliebigen Orten, nicht nur außerhalb des Fahrzeuginnenraums, eingebaut werden.

Eine weitere vorteilhafte Ausgestaltung der Erfindung ist der Patentanspruch 3.

Vorzugsweise wird die Flüssigkeitskühlung des Kühlbleches in den Kühlmittelkreislauf auch anderer Bauteile integriert. Üblicherweise ist eine Kühlmittelpumpe zum Transport des Kühlmittels vorgesehen, die erfindungsgemäß während des Betriebs des Batterieladegeräts auch bei Stillstand des Elektrofahrzeuges einschaltbar ist. Somit ist bei erhöhtem Kühlbedarf bestmögliche Kühlung gewährleistet.

Eine weitere Ausgestaltung der Erfindung ist der Gegenstand des Patentanspruchs 4.

Die Kühlmittelpumpe ist während des Betriebs des Batterieladegeräts temperaturabhängig einschaltbar. Dazu kann beispielsweise ein Sensor am Kühlblech, am Batterieladegerät oder innerhalb des Kühlmittels angebracht sein, der die Temperatur erfaßt und beispielsweise einer Steuereinheit zum Antrieb der Kühlmittelpumpe übermittelt, wobei die Steuereinheit die Kühlmittelpumpe einschaltet, wenn eine Temperaturschwelle überschritten ist. Mit dieser erfindungsgemäßen Weiterbildung wird die Kühlmittelpumpe nur bei Bedarf eingeschaltet, wodurch elektrische Energie eingespart wird.

Eine weitere vorteilhafte Ausgestaltung der Erfindung ist der Gegenstand des Patentanspruchs 5.

Die Kühlmittelpumpe ist alternativ auch zeitabhängig einschaltbar. Dazu kann beispielsweise eine Steuereinheit zum Antrieb der Kühlmittelpumpe einen Zeitzähler enthalten, der die Zeit erfaßt, innerhalb derer das Batterieladegerät in Betrieb ist. Überschreitet die Betriebszeit des Batterieladegeräts beispielsweise eine vorgegebene Zeitschwelle, wird die Kühlmittelpumpe eingeschaltet. Auch mit dieser erfindungsgemäßen Weiterbildung wird elektrische Energie eingespart, da die Kühlmittelpumpe nur bei Bedarf eingeschaltet wird.

In der Zeichnung ist ein Ausführungsbeispiel der Erfindung dargestellt. Es zeigt
Fig. 1 einen Kühlmittelkreislauf mit einer ersten Ausführungsform einer erfindungsgemäßen Kühlvorrichtung und
Fig. 2 eine zweite Ausführungsform einer erfindungsgemäßen Kühlvorrichtung.

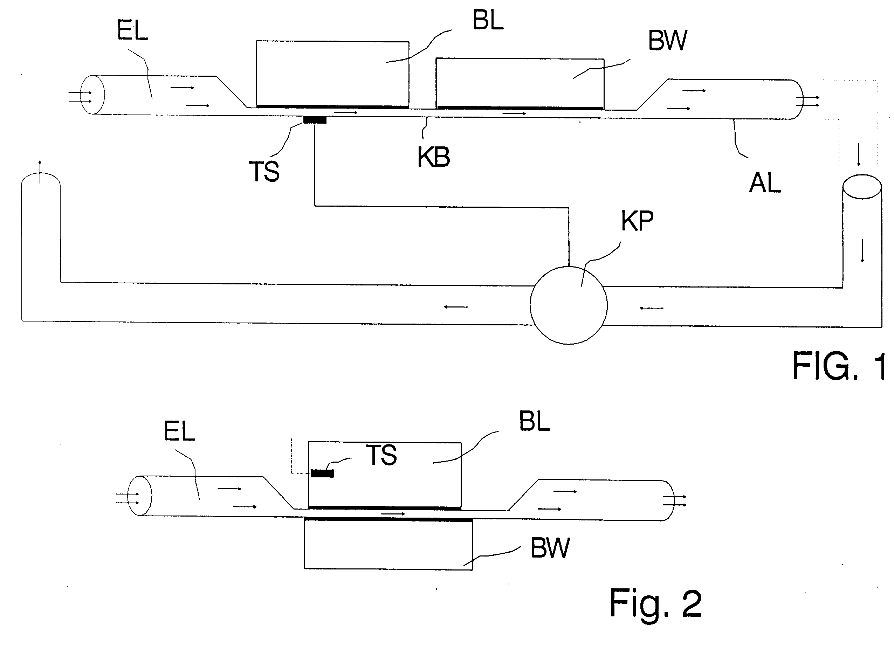

In Fig. 1 ist in einem geschlossenen Kühlmittelkreislauf ein hohles Kühlblech KB integriert, das von einem Einlaß EL zu einem Auslaß AL von einem Kühlmittel durchflossen wird. Weiterhin ist in dem Kühlmittelkreislauf eine Kühlmittelpumpe KP vorgesehen, durch die das Kühlmittel in angegebener Richtung transportiert wird. Auf dem hohlen Kühlblech KB sind das Batterieladegerät BL und der Bordnetzwandler BW nebeneinander befestigt, so daß eine möglichst gute Wärmeableitung erfolgt. An der der Befestigungsfläche des Batterieladegeräts gegenüberliegenden Seite des Kühlblechs KB ist ein Temperatursensor TS angeordnet, der mit der Kühlmittelpumpe KP, die eine hier nicht dargestellte Steuereinheit enthalten kann, verbunden ist.

In Fig. 2 ist eine weitere erfindungsgemäße Befestigungsvorrichtung dargestellt, bei der zum einen der Temperatursensor TS im Batterieladegerät BL, beispielsweise in der Nähe von elektrischen Leistungsbauteilen, angebracht ist und zum anderen das Batterieladegerät BL und der Bordnetzwandler BW sich einander gegenüberliegen. Dieses Ausführungsbeispiel ist gegenüber dem ersten Ausführungsbeispiel mit nebeneinander angeordneten Batterieladegerät BL und Bordnetzwandler BW platzsparender. Die Art der Anordnung ist je nach Bedarf auswählbar.

Ist während des Stillstands des Kraftfahrzeuges das Batterieladegerät in Betrieb und erfaßt der Temperatursensor TS eine Temperatur die größer als eine vorgegebene Temperaturschwelle ist, wird die Kühlmittelpumpe KP, die im Stillstand üblicherweise abgestellt ist, eingeschaltet. Sinkt durch den erhöhten Transport des Kühlmittels die Temperatur wieder unterhalb der vorgegebenen Temperaturschwelle ab, wird die Kühlmittelpumpe wieder ausgeschaltet.

Während des Betriebs des Elektrofahrzeuges ist zum einen die Kühlmittelpumpe KP ohnehin eingeschaltet und das Batterieladegerät BL ausgeschaltet, wodurch die gesamte Kühlleistung des Kühlblechs KB ausschließlich zur Kühlung des Bordnetzwandlers BW eingesetzt wird.

Somit ist bei Verwendung nur eines Kühlbleches sowohl für das Batterieladegerät als auch für den Bordnetzwandler bestmögliche Kühlung gewährleistet, wobei gleichzeitig eine Gewichts-, Platz- und Strömungsverlustreduzierung erreicht ist.

## Patentansprüche

1. Kühlvorrichtung für ein fahrzeuginternes Batterieladegerät (BL) und einen Bordnetzwandler (BW) in Elektrofahrzeugen, dadurch gekennzeichnet, daß das Batterieladegerät (BL) und der Bordnetzwandler (BW) an einem gemeinsamen Kühlblech (KB) befestigt sind.

2. Kühlvorrichtung nach Patentanspruch 1, dadurch gekennzeichnet, daß das Kühlblech (KB) flüssigkeitsgekühlt ist.

3. Kühlvorrichtung nach Patentanspruch 2, dadurch gekennzeichnet, daß eine Kühlmittelpumpe (KP) zum Transport des Kühlmittels vorgesehen ist, die während des Betriebs des Batterieladegeräts (BL) bei Stillstand des Elektrofahrzeuges einschaltbar ist.

4. Kühlvorrichtung nach Patentanspruch 3, dadurch gekennzeichnet, daß die Kühlmittelpumpe (KP) temperaturabhängig einschaltbar ist.

5. Kühlvorrichtung nach Patentanspruch 3, dadurch gekennzeichnet, daß die Kühlmittelpumpe (KP) zeitabhängig einschaltbar ist.

## Claims

1. A cooling device for a battery charger (BL) and an on-board transformer (BW) inside electric vehicles, characterised in that the battery charger (BL) and the on-board transformer (BW) are fastened to a common cooling plate (KB).

2. A cooling device according to claim 1, characterised in that the cooling plate (KB) is liquid-cooled.

3. A cooling device according to claim 2, characterised in that a coolant pump (KP) is provided for conveying the coolant and can be switched on during operation of the battery charger (BL) when the electric vehicle is stationary.

4. A cooling device according to claim 3, characterised in that the coolant pump (KP) can be switched on in dependence on the temperature.

5. A cooling device according to claim 3, characterised in that the coolant pump (KP) can be switched on in dependence on time.

## Revendications

1. Dispositif de refroidissement pour un chargeur de batterie (BL) embarqué dans le véhicule ainsi qu'un convertisseur de bord (BW), embarqué dans des véhicules électriques,
caractérisé en ce que
le chargeur de batterie (BL) et le convertisseur embarqués (BW) sont fixés à une tôle de refroidissement commune (KB).

2. Dispositif de refroidissement selon la revendication 1,
caractérisé en ce que
la tôle de refroidissement (KB) est refroidie par un liquide.

3. Dispositif de refroidissement selon la revendication 2,
caractérisé en ce que
la pompe de fluide de refroidissement (KP) est prévue pour faire circuler du fluide de refroidissement, cette pompe étant branchée pendant le fonctionnement du chargeur de batterie (BL) et pouvant également être mise en oeuvre lorsque le véhicule est arrêté.

4. Dispositif de refroidissement selon la revendication 2,
caractérisé en ce que
la pompe d'agent de refroidissement (KP) se branche en fonction de la température.

5. Dispositif de refroidissement selon la revendication 5,
caractérisé en ce que
la pompe de fluide de refroidissement (KP) est commandée en fonction du temps.
